# EUROPEAN PATENT APPLICATION

(11) **EP 0 553 774 A1**
(43) Date of publication of application: **04.08.1993**
(21) Application number: 93101167.0
(22) Date of filing: 27.01.1993
(51) Int. Cl.: H01L 27/092, H01L 27/06, H01L 21/82

(54) **Semiconductor device and method for producing the same**

(30) Priority: 28.01.1992 JP 35733/92
(71) Applicant: CANON KABUSHIKI KAISHA, Tokyo (JP)
(72) Inventor: Ishizaki, Akira, c/o Canon Kabushiki Kaisha, Ohta-ku- Tokyo 146 (JP)
(74) Representative: Tiedtke, Harro, Dipl.-Ing.

(57) **Abstract**

A semiconductor device comprises a first semiconductor layer formed on an insulating substrate, a second semiconductor layer laminated on the first semiconductor layer across an insulating layer, and a common gate attached to the two semiconductor layers across a gate insulation layer and extended in the laminating direction at least along lateral faces of the two semiconductor layers. A source area and a drain area are formed in respective side of the gate in each of the first and second semiconductor layers. A first MOS transistor is formed in the first semiconductor layer. A second MOS transistor is formed in the second semiconductor layer.

## Description

### BACKGROUND OF THE INVENTION

### Field of the Invention

The present invention relates to a semiconductor device formed by laminating plural MOS transistors on an insulating substrate, and a method for producing the same.

### Related Background Art

Formation of a monocrystalline Si semiconductive layer on an insulator has been widely known as the silicon-on-insulator (SOI) technology, and many investigations have been made because the devices utilizing the SOI technology have various advantages which cannot be attained with the bulk Si substrate utilized for ordinary Si integrated circuits. More specifically, the SOI technology can provide:
1) easy dielectric isolation leading to a higher level of integration;
2) excellent resistance to radiation;
3) reduced floating capacity, enabling a higher speed;
4) elimination of well process;
5) prevention of latch-up; and
6) thin film structure enabling a completely depleted field effect transistor.

For realizing the above-mentioned advantages in the device characteristics, researches have been made on the method of forming the SOI structure for many years, and these works are summarized for example in the special issue "Single-crystal silicon on non-single-crystal insulators" edited by G. W. Cullen, Journal of Crystal Growth, volume 63, No. 3, pp. 429 - 590 (1983).

In old days, there was known SOS (silicon-on-sapphire) technology in which Si is hetero epitaxially grown by CVD on monocrystalline sapphire substrate. Though this technology showed certain success as the most matured SOI technology, but the extension of its applications has been prevented by a large amount of crystal defects by the lattice dislocations between the Si layer and the underlying sapphire substrate, contamination of aluminum from the sapphire substrate into Si layer, expensiveness of the substrate and difficulty of large area formation.

In relatively recent years, there have been made attempts for forming the SOI structure without adopting the sapphire substrate. These attempts can be classified into following two categories:
1) A monocrystalline Si substrate is surfacially oxidized, then a window is opened to partially expose the Si substrate, and epitaxial growth is conducted in the lateral direction, utilizing said exposed part as a seed, thus forming a monocrystalline Si layer on SiO₂ (with Si deposition on SiO₂).
2) a monocrystalline Si substrate itself is used as an active layer, and SiO₂ is formed thereunder (without Si deposition in this case).

On a silicon layer formed by these methods on the insulator, there have been prepared various semiconductor devices and integrated circuits including such devices.

In the above-mentioned category (1), there have been known a method of direct lateral epitaxial growth of monocrystalline Si layer by CVD, a method of depositing amorphous Si and causing lateral solid-phase epitaxial growth by thermal treatment, a method of irradiating an amorphous or polycrystalline Si layer with a focused energy beam such as an electron beam or a laser beam to grow a monocrystalline layer on SiO₂ by molten recrystallization, and a method of zone melting recrystallization by moving a stripe-shaped molten zone with a rod-shaped heater. Although these methods have respective advantages and disadvantages, they in generally have many difficulties in the controllability, productivity, uniformity and quality, and none has been commercially practiced. For exmaple, the CVD method requires oxidation for forming a thin film, and the crystallinity is poor in the solid phase growth. Also the beam annealing method is associated with difficulties in the process time by the scanning with the focused beam, and in the controllability such as the overlapping and focusing of the beam. Among these methods, the zone melting recrystallization is closest to completion and relatively large integrated circuits have been prepared on trial basis, but there still remain plenty of crystal defects such as sub crystal grain boundaries and the technology level has not advanced to the preparation of minority carrier devices.

On the other hand, in the above-mentioned category (2) in which the Si substrate is not used as the seed for epitaxial growth, there have been known following methods:
1) A method of forming an oxidation film on a monocrystalline Si substrate on which V-shaped grooves are anisotropically etched, depositing a polycrystalline Si layer, on said oxidation film, with a thickness as large as that of the Si substrate, and polishing the Si substrate from the rear face thereof, thereby forming monocrystalline Si areas formed on the thick polycrystalline Si layer and dielectrically separated by the V-shaped grooves. Though this method provides satisfactory crystallinity, it has difficulty in the controllability and productivity in the step of depositing polycrystalline Si with a thickness of several hundred Angstroms, and in the step of polishing the monocrystalline Si substrate from the rear face, thereby leaving the separated active Si layer alone.
2) A SIMOX (separation by ion implanted oxygen) method, for forming a SiO₂ layer in a monocrystalline Si substrate by oxygen ion implantation. This method is currently most matured because of good matching with the Si process. However, the formation of SiO₂ layer requires the implantation of oxygen ions with a concentration of 10¹⁸ ions/cm² or higher, with an enormously long time for implantation. For this reason the productivity cannot be high, and the wafer cost is also high. Also there remain many crystal defects, so that this method has reached an industrial level enabling preparation of minority carrier devices.
3) A method of forming SOI structure by dielectric separation through oxidation of porous Si. This method consists of forming an N-type Si layer in island structure on a monocrystalline P-type Si substrate either by proton implantation (Imai et al., J. Crystal Growth, vol. 63, 547(1983)), or by epitaxial growth and patterning, then porosifying the P-type Si substrate only by effecting anodizing in HF solution from the surface so as to surround the Si island, and dielectrically separate the N-type Si island by accelerated oxidation. In this method, the freedom of device designing may be limited because the separated Si area is determined prior to the device process. Thus it has not been developed to a level enabling to exploit the above-mentioned advantages of the SOI structure in the semiconductor integrated circuits.

### SUMMARY OF THE INVENTION

In consideration of the foregoing, an object of the present invention is to provide a semiconductor device, capable of meeting the above-mentioned requirements, and a method of producing the same.

Another object of the present invention is to provide a semiconductor device enabling the achievement of a particularly high level of integration, and a method for producing the same.

Still another object of the present invention is to provide a semiconductor device excellent in productivity and economy.

Still another object of the present invention is to provide a semiconductor device comprising a first semiconductor layer formed on an insulating substrate, a second semiconductor layer laminated on said first semiconductor layer across an insulating layer, a common gate attached to said two semiconductor layers across gate insulating layer, said gate extending in the laminating direction at least along lateral faces of said two semiconductor layers, and source and drain areas formed on both sides of said gate in each of said first and second semiconductor layers, whereby a first MOS transistor is formed in said first semiconductor layer while a second MOS transistor is formed in said second semiconductor layer.

### BRIEF DESCRIPTION OF THE DRAWINGS

Figs. 1A and 1B are schematic views showing an embodiment of the semiconductor device of the present invention;
Fig. 2 is a schematic view of an anodizing apparatus to be employed in the preparation of the semiconductor device of the present invention;
Figs. 3 to 11 are schematic views showing steps for producing the semiconductor device shown in Fig. 1;
Fig. 12 is a circuit diagram of the semiconductor device shown in Fig. 1;
Fig. 13 is a plan view, seen from above, of the semiconductor device shown in Fig. 1;
Fig. 14 is a schematic view showing an embodiment of the semiconductor device of the present invention;
Fig. 15 is a circuit diagram of the semiconductor device shown in Fig. 1; and
Fig. 16 is a schematic view showing a conventional semiconductor device.

### DESCRIPTION OF THE PREFERRED EMBODIMENTS

In a preferred embodiment of the present invention, there is provided a semiconductor device comprising a first semiconductor layer formed on an insulating substrate; a second semiconductor layer laminated on said first semiconductor layer across an insulating layer; a common gate attached to said two semiconductor layers across a gate insulating layer, said gate extending in the laminating direction at least along the lateral faces of said two semiconductor layers; and source areas and drain areas formed on both sides of said gate in each of said first and second semiconductor layers, whereby a first MOS transistor is formed in said first semiconductor layer, and a second MOS transistor is formed in said second semiconductor layer.

Also in a preferred embodiment of the present invention, there is provided a method for producing a semiconductor device, comprising steps of adhering the surface or the oxidized surface of a non-porous monocrystalline silicon layer on a porosified first silicon substrate to the surface of an insulating substrate, then eliminating said porosified first silicon substrate by a process including at least wet chemical etching, thereby forming a first semiconductor layer consisting of non-porous monocrystalline silicon on the insulating substrate, then forming a source area and a drain area in predetermined positions in said first semiconductor layer, then adhering the surface or the oxidized surface of a non-porous monocrystalline silicon layer on a porosified second silicon substrate to the surface or the oxidized surface of the first semiconductor layer on said insulating substrate, in such a manner that at least an oxidized surface is present therebetween, then eliminating said porosified second silicon substrate by a process including at least chemical etching, thereby forming a second semiconductor layer consisting of non-porous monocrystalline silicon, across a silicon oxide insulating layer, on said first semiconductor layer provided on said insulating substrate, then forming a source area and a drain area in predetermined positions in said second semiconductor layer, and suitably patterning said first and second semiconductor layers to form a common gate, across a gate insulation layer, at least on the lateral faces of these two semiconductor layers.

In the semiconductor device of the present invention, one of said first and second MOS transistors can be made pMOS transistor while the other can be made nMOS transistor. Also the lead wire connected to the drain area of said first MOS transistor may be made to penetrate the drain area of said second MOS transistor in the laminating direction. The semiconductor device of the present invention can significantly increase the level of integration because of the laminated structure of MOS transistors.

Also the method of the present invention can produce the semiconductor devices of high performance with a high productivity and satisfactory economy, as the device is formed on a monocrystalline layer of high quality formed on an insulating substrate through selective elimination of porous silicon layer.

In the following the semiconductor device of the present invention and the producing method therefor will be explained, with reference to the attached drawings.

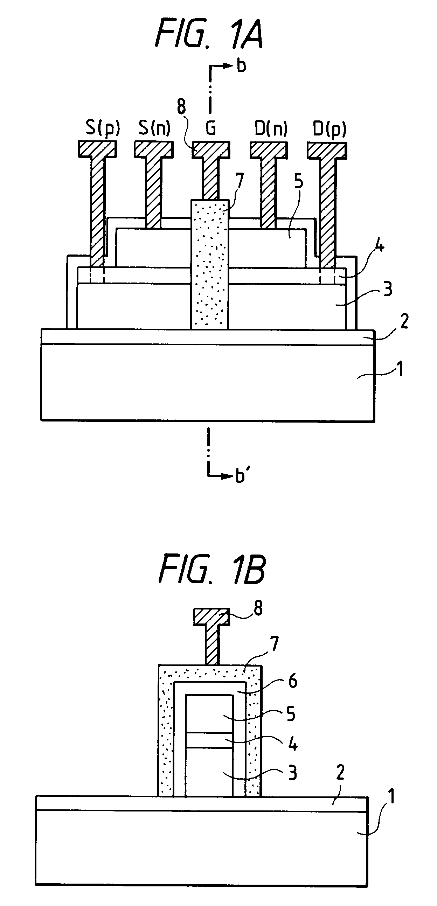

Fig. 1A is an elevation view, and Fig. 1B is a schematic cross-sectional view along a line b-b' in Fig. 1A, of an embodiment of the semiconductor device of the present invention.

Referring to Figs. 1A and 1B, there are shown a silicon substrate 1; an insulating layer 2; a first silicon layer 3; an insulating layer 4; a second silicon layer 5; a gate insulating layer 6; a gate 7; and wirings 8.

The first silicon layer 3 constitutes a pMOS transistor, in combination with the gate 7. In both side areas of the first silicon layer 3 there are respectively formed a p-source area and a p-drain area, which are respectively connected to wirings 8 represented by S(p) and D(p). Also the second silicon layer 5 constitutes an nMOS transistor in combination with the gate 7. In both side areas of the second silicon layer 5 there are respectively formed an n-source area and an n-drain area, which respectively connected to the wirings 8 represented by S(n) and D(n). Also the gate 7 is connected to a wiring 8 represented by G. As shown in these drawings, the gate 7 common to the laminated pMOS and nMOS transistors is shaped as a stripe and extends in the laminating direction on the lateral faces of the first silicon layer 3 and the second silicon layer 5.

In the following explained is the method for producing the above-explained semiconductor device.

At first, for facilitating the understanding, an explanation is given on porous silicon. Porous silicon was discovered by Uhlir et al. in 1956, in the course of investigation of electrolytic polishing of semiconductors (A. Uhlir, Bell Syst. Tech. J., vol. 35, p. 333 (1956)). Also Unagami et al. investigated dissolution of Si in anodizing, and reported that the anodic reaction of Si in HF solution required positive holes with the following reaction mechanisms (T. Unagami: J. Electrochem. Soc., vol. 127, p. 476 (1980)):

Si + 2HF + (2 - n)e⁺ → SiF₂ + 2H⁺ + ne⁻ SiF₂ + 2HF → SiF₄ + H₂ SiF₄ + 2HF → H₂SiF₆

or

Si + 4HF + (4 - λ)e⁺ → SiF₄ + 4H⁺ + λe⁻ SiF₄ + 2HF → H₂SiF₆

wherein e⁺ and e⁻ respectively represent positive hole and electron. Also n and λ indicate the number of positive holes required for dissolution of an atom of silicon, and it was reported that porous silicon was formed when a condition n > 2 or λ > 4 was satisfied.

In this manner positive holes are required for the formation of porous silicon, so that p-type silicon is more easily transformed, than n-type silicon, into porous silicon. It is however already known that n-type Si can also be transformed into porous silicon by positive hole injection (R. P. Holmstorm, I. J. Y. Chi; Appl. Phys. Lett. Vol. 42, 386 (1983)).

In contrast to monocrystalline Si having a fixed density of 2.33 g/cm³, porous Si has variable density in a range of 1.1 to 0.6 g/cm³ corresponding to the concentration of HF solution from 50 to 20%. According to the observation under a transmissive electron microscope, the porous Si has pores of average diameter of about 600 Å. Despite that the density is less than half of that of monocrystalline Si, porous Si maintains monocrystalline character, so that a monocrystalline Si layer can be epitaxially grown on the surface thereof. Also because of the decrease of density to less than half by a large amount of spaces therein, porous Si shows a drastic increase in the surface area in comparison with the volume thereof, so that the chemical etching rate becomes significantly larger in comparison with that of non-porous silicon.

In the following there will be explained the method for forming the porous Si layer by anodizing.

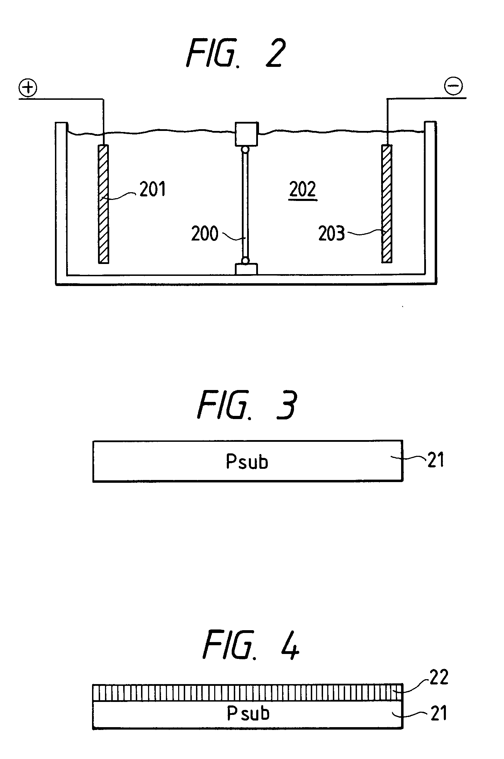

Fig. 2 schematically illustrates an apparatus for said anodizing. At first a p-type monocrystalline Si substrate 200 is set in said apparatus, whereby said substrate 200 is in contact with hydrofluoric acid solution 22 in which a cathode 203 and an anode 201 are positioned on respective sides of the substrate 200. Porosification takes place from the cathode side of the substrate 200 maintained in contact with the hydrofluoric acid solution. The hydrofluoric acid solution generally consists of concentrated hydrofluoric acid (49% HF). For efficiently eliminating bubbles generated from the surface of the substrate 200 in the course of anodizing, alcohol, such as methanol, ethanol, propanol or isopropanol may be added as a surfactant. Instead of surfactant addition, there may be employed agitation with an agitator. The electrodes 201, 203 are composed of a material not attacked by the hydrofluoric acid solution 202, such as gold (Au) or platinum (Pt). The anodizing may be conducted with a suitable current not exceeding several hundred milliampere per square centimeter. Said current is suitably selected within a range in which satisfactory epitaxial growth can be obtained on the porosified silicon surface. In general, a larger current increases the rate of anodizing and reduces the density of the porous Si layer, increasing the volume of spaces. Consequently the conditions of epitaxial growth are affected.

In the following there will be explained in more details the process of preparation of the semiconductor device shown in Fig. 1.

At first there is prepared a p-Si substrate 21 as shown in Fig. 3, and there is prepared, on the surface thereof, a porous layer 22 of a thickness of about 50 µm by the above-explained anodizing, as shown in Fig. 4.

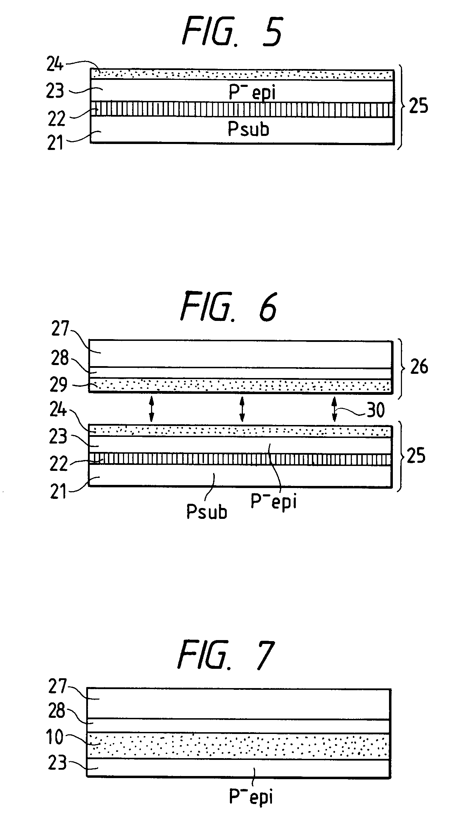

Then, on the porous Si layer 22, a low-concentration p-epitaxial layer 23 is formed as shown in Fig. 5, with a thickness for example of 5,000 Å. The epitaxial growth can be conducted with low pressure CVD with following conditions:
- Raw material gas:: SiH₄
- Carrier gas:: H₂
- Temperature:: 850°C
- Pressure:: 1 x 10⁻² Torr
- Growth rate:: 3.3 nm/sec.

Then on the epitaxial layer 23, there is formed a thermal oxidation layer 24 with a thickness for example of 500 Å. In this manner a wafer 25 is prepared.

An opponent wafer 26, to be adhered to the wafer 25, can be obtained, as shown in Fig. 6, by forming a SiN layer 28 and a silicon oxide layer 29 thereon on the face, to be adhered, of a Si substrate 27. The thicknesses of said layers 28, 29 can be, for example, several microns.

These two wafers 25, 26 are mutually adhered, as shown in Fig. 6, by faces 30 thereof. Said adhesion can be attained, for example, in the following manner. At first the faces to be mutually adhered are washed, by rinsing with deionized water and washing with a mixture of sulfuric acid (H₂SO₄) and hydrogen peroxide, a mixture of hydrochloric acid (HCl) and hydrogen peroxide, hydrofluoric acid, a mixture of hydrofluoric acid and hydrogen peroxide, aqueous ammonia solution, deionized water or a mixture thereof. Then the oxide films 24 and 29 mutually adhere by mere superposition, without any heat treatment, unless external stress is applied. This adhesion is due to hydrogen bonding at the interface of said oxide films. Subsequently, the wafers adhered by hydrogen bonding are subjected to heat treatment, at a temperature of 600°C or higher in an atmosphere of oxygen, nitrogen hydrogen or rare gas. In general the interfacial bonding force becomes stronger as the heat treatment temperature becomes higher. This is because, at a temperature of 200°C or higher, the hydrogen and oxygen atoms, forming the hydrogen bonds, are cleaved in the form of H₂O, thereby leaving silanol (Si-O-Si) bonds. However the bonding force is still limited while the cleaved H₂O molecules remain as voids in the vicinity of the interface, and becomes highest when said voids are completely removed by diffusion. Said bonding force is saturated at about 900°C. Then annealing is conducted for 2 hours, in an annealing oven, in nitrogen atmosphere.

After said adhesion, the p-Si substrate 21, if still remaining, is lapped off until the porous layer 22 becomes exposed. Then said porous layer 22 alone is removed by etching with an etchant of a high selective ratio for the non-porous Si and porous Si. Examples of preferred etchant includes hydrofluoric acid buffered hydrofluoric acid, and a mixture of hydrofluoric acid or buffered hydrofluoric acid and alcohol (ethyl alcohol, isopropyl alcohol etc.) and/or hydrogen peroxide. Addition of alcohol enables instantaneous elimination of the bubbles of reaction gas of etching from the etched surface without agitation, and achieves uniform and efficient etching of porous Si. Also the addition of hydrogen peroxide accelerates the oxidation of silicon and increases the reaction rate, and the reaction rate can be controlled by the proportion of hydrogen peroxide. The concentration of solution and the temperature are suitably selected within a range in which hydrofluoric acid, buffered hydrofluoric acid, hydrogen peroxide and/or alcohol are respectively effective and the etching rate is acceptable in the production process.

In case of employing hydrofluoric acid, the HF concentration in the etching solution is preferably selected within a range of 1 - 95%, more preferably 5 - 90% and most preferably 5 - 80%. In case of buffered hydrofluoric acid, the HF concentration in the etching solution is preferably within a range of 1 - 95%, more preferably 1 - 85% and most preferably 1 - 70%, and the NH₄F concentration is preferably selected within a range of 1 - 95%, more preferably 5 - 90% and most preferably 5 - 80%.

The H₂O₂ concentration in the etching solution is selected preferably within a range of 1 - 95%, more preferably 5 - 90% and most preferably 10 - 80% and within a range in which the above-mentioned effect of hydrogen peroxide can be obtained. The alcohol concentration in the etching solution is selected preferably within a range of 80% or less, more preferably 60% or less and most preferably 40% or less, and within a range in which the above-mentioned effect of alcohol can be obtained.

The temperature is selected preferably within a range of 0 - 100°C, more preferably 5 - 80°C and most preferably 5 - 60°C.

For example the porous layer 22 can be etched without agitation, by immersion in a mixture of 49% hydrofluoric acid, alcohol and 30% hydrogen peroxide (10 : 6 : 50), whereby the porous layer 22 of 50 µm can be etched in about 1 minute. Thus there can be obtained, as shown in Fig. 7, an SOI wafer bearing, on the Si substrate 27, a SiN layer 28, a silicon oxide layer 10 and a p⁻ epitaxial layer 23.

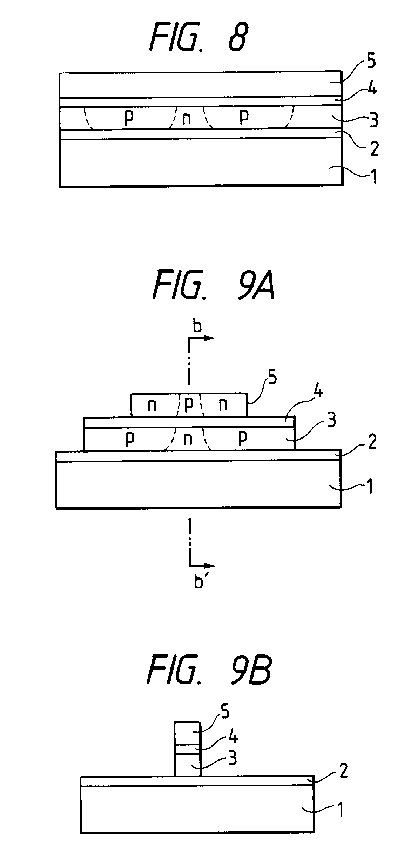

In this manner there is obtained a structure bearing a first semiconductor layer 23, on the Si substrate 27 with the insulating layers (28 + 10), or on an insulating substrate. Stated differently, with reference to Fig. 8, there is obtained a structure bearing, on a Si substrate 1, a first silicon layer 3 across an insulating layer 2.

Then, p- and n-areas are formed, for example by ion implantation, in predetermined areas of the first silicon layer 3 as the source and drain areas of pMOS transistor, as shown in Fig. 8. Subsequently said layer is used as the layer 27 in the above-explained adhesion step shown in Fig. 6 and a similar step is thereafter executed to obtain a structure in which, as shown in Fig. 8, a second silicon layer 5 is formed on the first silicon layer 3 across an insulation layer 4.

Then, as shown in Fig. 9A, p- and n-type areas are formed, for example by ion implantation, in predetermined positions of the second silicon layer 5, as the source and drain areas of the nMOS transistor, respectively corresponding to the above-mentioned source and drain areas of the pMOS transistor mentioned above. Subsequently, as shown in Fig. 9A, the first silicon layer 3, insulating layer 4 and second silicon layer 5 are patterned in predetermined forms, for the purpose of device isolation in case plural laminated MOS transistors are formed on the silicon substrate 1 and the insulating layer 2. Fig. 9B is a schematic cross-sectional view along a line b-b' in Fig. 9A.

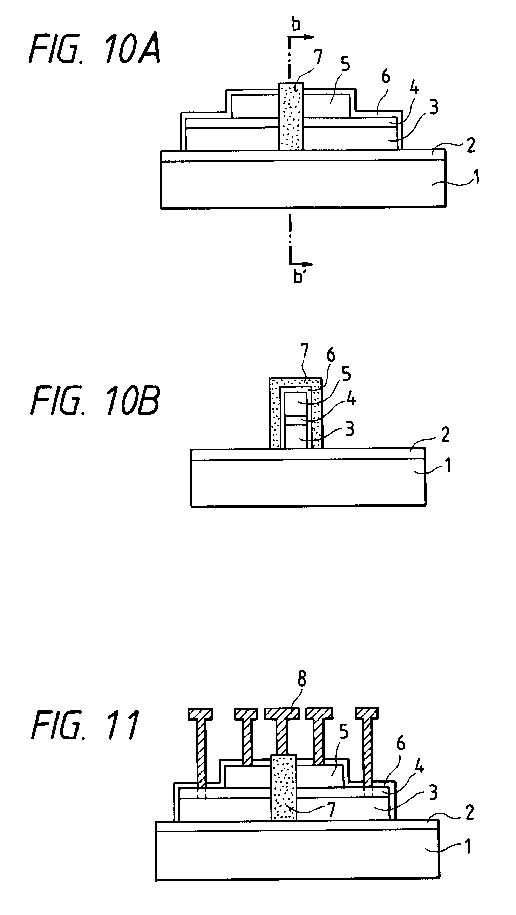

Then, as shown in Fig. 10A, the first silicon layer 3, the insulating layer 4 and the second silicon layer 5 are covered with a gate insulation layer 6, on which a gate 7 is formed for example by patterning of polysilicon. Said gate 7 is positioned at the center of the source and drain areas formed in the first and second silicon layers 3, 5, whereby obtained is a laminated structure in which the pMOS transistor and the nMOS transistor having said gate 7 in common are laminated. As an alternative method, the source and drain areas in the second silicon layer 5 may be formed after the formation of the gate 7, utilizing said gate 7 as the mask. Fig. 10B is a schematic cross-sectional view along a line b-b' in Fig. 10A.

Subsequently, as shown in Fig. 11, wirings 8 are formed for connection with the source and drain areas of the pMOS transistor formed in the first silicon layer 3, the source and drain areas of the nMOS transistor formed in the second silicon layer 5, and the gate 7. Before and after the formation of said wirings 8, there are formed, in known manner, an interlayer insulation film and a protective film, which are however omitted from illustration.

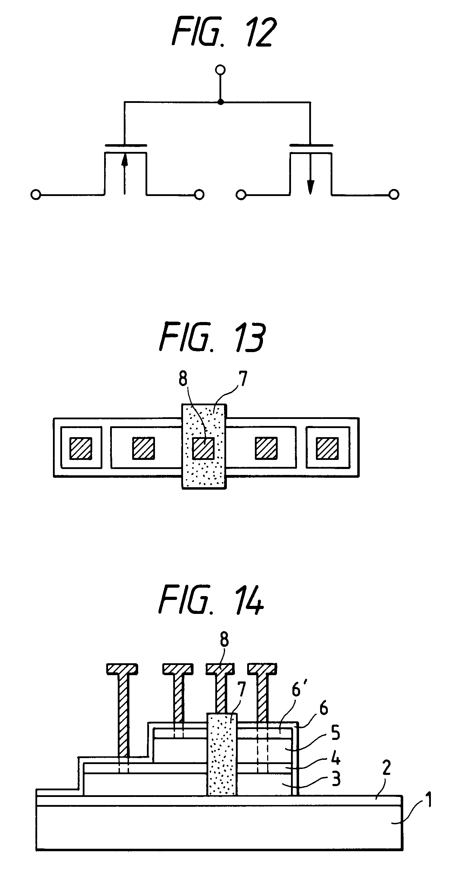

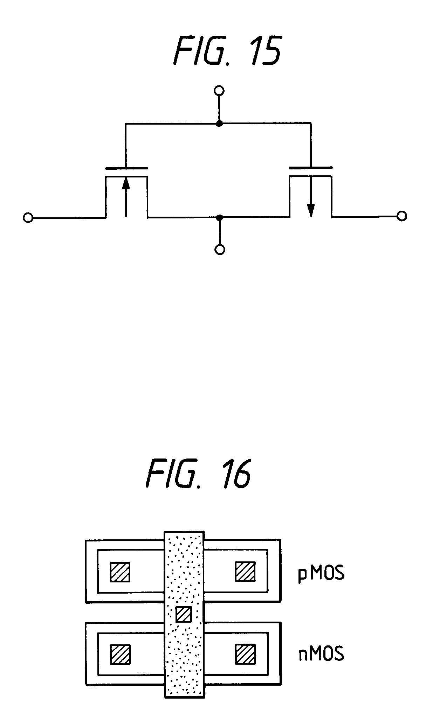

Through these steps there is obtained a semiconductor device shown in Fig. 1, of which circuit structure is shown in Fig. 12. Fig. 13 is a plan view, seen from above, of the semiconductor device shown in Fig. 1A, while Fig. 16 is a corresponding view of a conventional semiconductor device. From comparison of Figs. 13 and 16 it will be understood that the semiconductor device of the present invention can be made in compacter form.

As explained in the foregoing, the present embodiment can increase the level of integration since two MOS transistors are laminated vertically.

Fig. 14 is a schematic view of another embodiment of the semiconductor device of the present invention, wherein components same as or equivalent to those in Fig. 1A are represented by same numbers. Fig. 14 is a view equivalent to Fig. 1A. The present embodiment is different from the foregoing embodiment shown in Fig. 1A in that the drain area of the pMOS transistor in the first silicon layer 3 is directly connected, through a common wiring 8, to the drain area of the nMOS transistor in the second silicon layer 5, thereby partly simplifying the external wirings and providing a CMOS structure of which circuit structure is shown in Fig. 15. Also the level of integration can be further increased as the dimension of MOS transistors can be further reduced.

The present embodiment is also different in that an insulation layer 6' is formed on the second silicon layer 5.

The MOS transistors in the foregoing embodiments are laminated in two layers, but laminated structures in three or more layers may also be obtained in a similar manner.

As detailedly explained in the foregoing, the semiconductor device of the present invention can significantly improve the level of integration, since MOS transistors are laminated by forming a common gate on the lateral faces of laminated plural semiconductor layers.

Also the method of the present invention enables to obtain semiconductor devices of high performance with satisfactory productivity, process control, uniformity and economy, since device is formed in a monocrystalline layer of satisfactory quality, which is formed on an insulating substrate by selective elimination of porous silicon substrate.

A semiconductor device comprises a first semiconductor layer formed on an insulating substrate, a second semiconductor layer laminated on the first semiconductor layer across an insulating layer, and a common gate attached to the two semiconductor layers across a gate insulation layer and extended in the laminating direction at least along lateral faces of the two semiconductor layers. A source area and a drain area are formed in respective side of the gate in each of the first and second semiconductor layers. A first MOS transistor is formed in the first semiconductor layer. A second MOS transistor is formed in the second semiconductor layer.

## Claims

1. A semiconductor device comprising a first semiconductor layer formed on an insulating substrate, a second semiconductor layer laminated on said first semiconductor layer across an insulating layer, and a common gate attached to said two semiconductor layers across a gate insulation layer and extended in the laminating direction at least along lateral faces of said two semiconductor layers, wherein a source area and a drain area are formed in respective side of said gate in each of said first and second semiconductor layers, whereby a first MOS transistor is formed in said first semiconductor layer and a second MOS transistor is formed in said second semiconductor layer.

2. A semiconductor device according to claim 1, wherein one of said first and second MOS transistors is a pMOS transistor and the other is an nMOS transistor.

3. A semiconductor device according to claim 1, wherein a wiring connected to the drain area of said first MOS transistor penetrates, in the laminating diretion, the drain area of said second MOS transistor.

4. A semiconductor device according to claim 1, wherein said insulating substrate is obtained by forming an insulating layer on the surface of silicon.

5. A semiconductor device according to claim 1, wherein said first and second semiconductor layers are composed of monocrystalline silicon layers.

6. A method for forming a semiconductor device, comprising steps of:
forming a first semiconductor layer of non-porous monocrystalline silicon on an insulating substrate, by adhering the surface or oxidized surface of a non-porous monocrystalline silicon layer formed on a porosified first silicon substrate to the surface of an insulating substrate, and then eliminating said porosified first silicon substrate by a process including at least wet chemical etching;
forming a source area and a drain area in predetermined positions of said first semiconductor layer;
forming a second semiconductor layer of non-porous monocrystalline silicon, across a silicon oxide insulation layer, on the first semiconductor layer present on said insulating substrate, by adhering the surface or oxidized surface of a non-porous monocrystalline silicon layer formed on a porosified second silicon substrate to the surface or oxidized surface of the first semiconductor layer present on said insulating substrate in such a manner that at least an oxidized surface is present therebetween, and then eliminating said porous second silicon substrate by a process including at least chemical etching;
forming a source area and a drain area in predetermined positions in said second semiconductor layer; and
suitably patterning said first and second semiconductor layers and forming, by patterning, a common gate, across a gate insulation layer, on at least lateral faces of said two semiconductor layers.
